# DEMANDE DE BREVET EUROPEEN

(11) **EP 2 624 175 A1**
(43) Date de publication de la demande: **07.08.2013**
(21) Numéro de dépôt: 13305141.7
(22) Date de dépôt: 06.02.2013
(51) Int. Cl.: G06K 17/00, G06K 7/10, G06K 19/077

(54) **Système et procédé de localisation automatique d'objets positionnés de manière amovible dans des emplacements prédéfinis, et mettant en oeuvre des marqueurs RFID actifs**

(30) Priorité: 06.02.2012 FR 1251084
(71) Demandeur: Domine, François, 38190 Bernin (FR)
(72) Inventeur: Domine, François, 38190 Bernin (FR)
(74) Mandataire: Matkowska, Franck

(57) **Abrégé**

Le système permet la localisation d'objets (El), tels que des serveurs informatiques, destinés à être positionnés de manière amovible dans des emplacements prédéfinis (B_{i,j}), tels que les emplacements d'une baie informatique Bᵢ.

Le système comporte des marqueurs RFID (M) actifs , qui sont chacun identifiés par un identifiant unique (ID_M), chaque marqueur RFID étant destiné à être fixé sur un objet à localiser. Chaque marqueur RFID actif (M) comporte des moyens électroniques de détection (5) d'un rayonnement électromagnétique d'activation de manière à pouvoir être réveillé individuellement par un rayonnement électromagnétique d'activation, et des moyens d'émission radiofréquence (3) qui sont distincts des moyens électroniques de détection (5), et est conçu pour émettre automatiquement par radiofréquence au moins son identifiant (ID_M) unique chaque fois qu'il est réveillé par un rayonnement électromagnétique d'activation. Le système comporte en outre des moyens électroniques de localisation (Clᵢ) qui sont aptes à recevoir les identifiants (ID_M) émis par radiofréquence par les marqueurs RFID actifs, et qui sont conçus pour, après chaque émission d'un rayonnement électromagnétique d'activation, localiser automatiquement un marqueur RFID actif (M) qui a été réveillé, en utilisant la position d'émission connue du rayonnement électromagnétique d'activation dernièrement émis et l'identifiant (ID_M) qui a été reçu après émission dudit rayonnement électromagnétique d'activation.

## Description

### Domaine technique

La présente invention concerne la localisation automatique, au moyen de marqueurs RFID, d'objets positionnés de manière amovible dans des emplacements prédéfinis. Elle trouve plus particulièrement, mais non exclusivement, son application à la localisation automatique d'équipements informatiques, de type serveurs ou routeurs, dans des baies informatiques d'un centre d'hébergement de données, plus communément désigné « data center ».

### Art antérieur

La radio-identification plus communément désignée par le sigle RFID (Radio Frequency IDentification) est une méthode aujourd'hui largement répandue pour mémoriser et récupérer des données à distance en utilisant des marqueurs RFID, encore également appelés balises RFID, tags RFID, étiquettes RFID, ou radio-étiquettes. Dans la suite du présent texte, la désignation « marqueur RFID » sera utilisée.

Un marqueur RFID est caractérisé par un identifiant ID unique qui lui est propre, et qui le différencie des autres marqueurs RFID. Il comporte généralement une antenne associée à une puce électronique stockant au moins ledit identifiant ID, et le cas échéant d'autres données susceptibles d'être transmises par le marqueur RFID. Les marqueurs RFID sont conçus pour communiquer à distance et sans fil avec un lecteur adapté ou avec un récepteur adapté, de manière à pouvoir transmettre au moins leur identifiant ID.

Il existe deux types de marqueurs RFID, à savoir les marqueurs RFID passifs et les marqueurs RFID actifs.

Un marqueur RFID passif n'intègre pas sa propre source d'alimentation, et est conçu pour fonctionner avec un lecteur, qui permet d'interroger à distance un marqueur RFID passif en se couplant magnétiquement avec ledit marqueur RFID passif. A chaque interrogation du marqueur RFID passif, le lecteur fournit à ce marqueur RFID passif l'énergie nécessaire à son fonctionnement, au travers de la boucle magnétique créée par le couplage. Ce type de solution impose un couplage magnétique à faible distance, typiquement inférieure à quelques mètres, entre le lecteur et le marqueur RFID passif.

A la différence d'un marqueur RFID passif, un marqueur RFID actif est en permanence alimenté électriquement, indépendamment de tout lecteur ou récepteur, et par exemple comporte à cet effet une source d'alimentation embarquée autonome. Plus particulièrement, les marqueurs RFID actifs sont le plus souvent conçus pour émettre automatiquement et périodiquement des données, dont au moins leur identifiant ID, sans attendre un signal d'interrogation d'un lecteur, et pour, entre deux émissions successives, se mettre automatiquement dans un mode de fonctionnement dit de « veille », de manière à consommer le moins d'énergie possible. Egalement, un marqueur RFID actif peut être conçu pour émettre son identifiant ID en réponse à un signal d'interrogation reçu par radiofréquence.

Les marqueurs RFID sont des objets de très petites dimensions, qui peuvent avantageusement être fabriqués en très grande quantité et à faible coût. Ils sont par conséquent à ce jour largement utilisés dans de très nombreux domaines d'applications différents pour réaliser l'identification à distance d'objets, en étant fixés sur chaque objet à identifier. Plus particulièrement, les marqueurs RFID sont à ce jour utilisés pour permettre la localisation et le suivi à distance d'objets dans différents domaines d'applications.

Une application connue des marqueurs RFID est la localisation à distance d'équipements informatiques, tels que des serveurs informatiques ou des routeurs informatiques dans un centre d'hébergement de données, plus communément désigné « data center ».

Un data center comprend généralement plusieurs salles d'hébergement contenant chacune de nombreuses armoires de stockage intégrant de la connectique avec un réseau informatique, et communément désignées baies. Chaque baie informatique peut contenir plusieurs serveurs informatiques et le cas échéant plusieurs routeurs informatiques, rangés à des emplacements prédéfinis dans la baie.

Ces équipements informatiques (serveur, routeurs, dispositifs de stockage de données...) peuvent être déplacés en fonction des besoins et disponibilités du data center et des équipements informatiques (serveur, routeurs) peuvent être ajoutés, retirés ou remplacés. Il est par conséquent essentiel pour le gérant d'un data center de pouvoir localiser facilement et en permanence chaque serveur ou routeur parmi l'ensemble des serveurs ou routeurs du data center. La satisfaction de ce besoin est d'autant plus importante aujourd'hui que le nombre de serveurs et routeurs d'un data center est élevé et continuera certainement d'augmenter à l'avenir.

On a déjà proposé, notamment dans la demande de brevet américain US-A-2004/0178270, dans la demande de brevet internationale WO-A-2011/025530 et dans la demande de brevet américain US-A-2009/020722 d'utiliser la technologie RFID pour réaliser la localisation à distance de serveurs dans un data center.

Les solutions proposées dans la demande de brevet américain US-A-2004/0178270, dans la demande de brevet internationale WO-A-2011/025530 et dans la demande de brevet américain US-A-2009/020722 sont basées sur l'utilisation de marqueur RFID passifs.

Plus particulièrement dasn ces publications on fixe un marqueur RFID passif sur chaque serveur à localiser, et la baie informatique comprend, à chaque emplacement (slot) d'un serveur, un lecteur permettant d'interroger le marqueur RFID passif d'un serveur présent dans ledit emplacement et de fournir l'énergie nécessaire au fonctionnement dudit marqueur RFID passif.

Cette solution technique présente l'inconvénient majeur d'obliger à équiper chaque baie informatique avec un lecteur par emplacement (slot) de serveur, ce qui augmente considérablement les coûts de mise en oeuvre, et de maintenance de cette solution technique. Au surplus, il peut arriver qu'un lecteur soit en panne ou fonctionne mal, ou qu'un marqueur soit mal positionné par rapport à son lecteur. Dans ce cas, le serveur positionné dans l'emplacement correspondant à ce lecteur n'est jamais détecté.

La demande de brevet américain US 2009/020722 propose une solution technique comparable à celle de la demande de brevet internationale WO-A-2011/025530, avec une mise en oeuvre de lecteurs incorporés dans des rubans facilitant leur mise en place dans une baie informatique.

La solution technique décrite dans la demande de brevet américain US 2009/020722 repose en outre sur la mise en oeuvre pour chaque lecteur d'une bobine interrogatrice générant un champ magnétique destinée être couplé au marqueur RFID passif, de manière à lui fournir son énergie et de manière à détecter l'identifiant ID du marqueur en fonction de la variation du signal de la bobine interrogatrice.

L'énergie électromagnétique générée par ces bobines est très sensible à l'environnement métallique voisin. En outre cet environnement est différent au voisinage d'un serveur à l'autre. Il est par conséquent impossible de régler avec précision l'énergie diffusée sur chaque bobine, ce qui peut perturber de manière préjudiciable la détection d'un identifiant ID d'un marqueur RFID, et dans certains cas fausser complètement la détection d'un identifiant ID d'un marqueur RFID, ou pire ne pas détecter cet identifiant ID.

Par ailleurs, avec ce type de solution, il y a également un risque de couplage avec un marqueur RFID d'un serveur placé dans un emplacement voisin qui ne correspond pas à l'emplacement du lecteur, ce qui occasionne une fausse détection.

Egalement, avec ce type de solution, de la manière comparable à la solution décrite dans la demande de brevet internationale WO-A-2011/025530, si le marqueur RFID passif est mal positionné par rapport à son lecteur, aucune détection n'est possible, et l'identifiant ID d'un marqueur RFID passif mal positionné n'est jamais détecté.

La mise en oeuvre de marqueurs RFID actifs permettrait de résoudre les inconvénients susmentionnés liés à la détection des identifiants ID de marqueurs RFID passifs, mais elle présente en pratique l'inconvénient majeur de ne pas permettre une localisation suffisamment précise de la position des marqueurs RFID actifs. La mise en oeuvre de marqueurs RFID actifs est donc à ce jour considéré comme inadaptée pour localiser de manière suffisamment précise des objets positionnés de manière amovibles dans des emplacements prédéfinis, tels que notamment des serveurs ou routeurs dans des baies informatiques.

Dans la demande de brevet américain US-A-2011/0084839, il est proposé de remplacer les marqueurs RFID par une solution filaire mettant en oeuvre des marqueurs connectés à un ordinateur de contrôle par des liaisons filaires pour la transmission des identifiant ID des marqueurs.

Par rapport à une solution sans fil, cette solution technique basée sur une technologie filaire présente l'inconvénient d'être plus lourde à mettre en oeuvre et également très coûteuse à cause notamment de la longueur importante de câbles électriques à déployer. Elle est en outre moins flexible et plus contraignante à utiliser. Par exemple, chaque fois qu'un serveur doit être déplacé, il faut déconnecter physiquement le marqueur du réseau, pour ensuite le reconnecter physiquement au réseau une fois le serveur positionné dans son nouvel emplacement.

### Résumé de l'invention

La présente invention vise à proposer une nouvelle solution de localisation à distance, au moyen de marqueurs RFID, d'objets destinés à être positionnés de manière amovible dans des emplacements prédéfinis.

L'invention est ainsi relative à un système pour la localisation d'objets destinés à être positionnés de manière amovible dans des emplacements prédéfinis, ledit système présentant les caractéristiques techniques de la revendication 1

Plus particulièrement, mais de manière facultative selon l'invention, le système de l'invention peut comporter les caractéristiques techniques additionnelles et optionnelles ci-après, prises isolément ou en combinaison :
- Les moyens électroniques de localisation sont conçus pour, après chaque émission d'un rayonnement électromagnétique d'activation, localiser automatiquement un marqueur RFID actif qui a été réveillé en enregistrant dans une mémoire, la position d'émission connue du rayonnement électromagnétique d'activation dernièrement émis, en lien avec l'identifiant (ID_M) qui a été reçu.
- Chaque marqueur RFID comporte des moyens de réception radiofrequence ; les moyens électroniques de localisation sont identifiés par un identifiant unique (ID_Clᵢ), et sont conçus pour, après chaque émission d'un rayonnement électromagnétique d'activation et en cas de réception d'un identifiant (ID_M) d'un marqueur (M), émettre, par radiofréquence, leur identifiant unique (ID_Clᵢ), et l'identifiant (ID_M) du marqueur RFID actif qui a été reçu après émission dudit rayonnement électromagnétique d'activation ; le marqueur RFID actif identifié par l'identifiant (ID_M) émis par les moyens électroniques de localisation (Clᵢ) est conçu pour enregistrer dans une mémoire locale du marqueur l'identifiant unique (ID_Clᵢ) émis par les moyens électroniques de localisation.
- Chaque marqueur RFID actif est conçu pour automatiquement émettre périodiquement par radiofréquence au moins son identifiant (ID_M).
- Chaque marqueur RFID actif est conçu pour automatiquement émettre périodiquement par radiofréquence au moins son identifiant (ID_M) et au moins une autre information, qui peut être l'identifiant (ID_Clᵢ) des moyens électroniques de localisation (Clᵢ), ou une information (« LIBRE ») indiquant qu'il n'a pas encore été localisé par les moyens électroniques de localisation (Clᵢ).
- Les moyens électroniques de localisation comportent des moyens d'émission qui sont aptes à émettre un rayonnement électromagnétique d'activation séquentiellement depuis plusieurs positions d'émission prédéfinies et différentes correspondant respectivement aux emplacements prédéfinis.
- Les moyens d'émission d'un rayonnement électromagnétique comportent plusieurs émetteurs distincts aptes chacun à émettre un rayonnement électromagnétique d'activation, chaque émetteur ayant une position fixe correspondant à un emplacement à raison d'un émetteur par emplacement.
- Les moyens électroniques de localisation sont conçus pour commander séquentiellement les émetteurs distincts afin qu'ils génèrent chacun à leur tour un signal électromagnétique d'activation.
- Les émetteurs sont des diodes électroluminescentes.
- Les émetteurs sont fixés sur un support rigide avec un espacement entre les émetteurs correspondant à l'espacement entre les emplacements.
- Les moyens d'émission d'un rayonnement électromagnétique comportent un émetteur de rayonnement électromagnétique d'activation, qui est mobile de manière à pouvoir être positionné dans des positions différentes correspondant respectivement aux emplacements prédéfinis.
- L'émetteur de rayonnement électromagnétique d'activation est une source laser mobile.
- Les moyens électroniques de localisation comportant au moins des moyens de réception radiofréquence, et de préférence également des moyens d'émission radiofréquence, qui permettent aux moyens électroniques de localisation de communiquer à distance par radiofréquence avec les marqueurs RFID (M), lesdits moyens de réception radiofréquence, et le cas échéant lesdits moyens d'émission radiofréquence, sont distincts des moyens d'émission du rayonnement électromagnétique d'activation.
- Chaque rayonnement électromagnétique d'activation est un rayonnement (ou faisceau) directif.
- Chaque rayonnement électromagnétique d'activation est un signal infrarouge.
- Chaque marqueur RFID actif comporte sa propre source d'alimentation électrique autonome.

L'invention concerne également un procédé de localisation d'objets, tel que défini dans la revendication 16.

Plus particulièrement, mais de manière facultative selon l'invention, le procédé de l'invention peut comporter les caractéristiques techniques additionnelles et optionnelles ci-après, prises isolément ou en combinaison :
- On réitère successivement les étapes (a) à (c) pour chaque emplacement prédéfini.
- A l'étape (c), les moyens électroniques de localisation localisent automatiquement l'objet dont le marqueur RFID actif été réveillé, en enregistrant dans une mémoire, la position d'émission connue du rayonnement électromagnétique d'activation dernièrement émis, en lien avec l'identifiant (ID_M) qui a été reçu.
- Les moyens électroniques de localisation qui sont identifiés par un identifiant unique (ID_Clᵢ), dans lequel, après chaque émission d'un rayonnement électromagnétique d'activation, et en cas de réception d'un identifiant (ID_M) d'un marqueur (M) par les moyens électroniques de localisation, les moyens électroniques de localisation émettent par radiofréquence leur identifiant unique

(ID_Clᵢ), et l'identifiant (ID_M) du marqueur RFID actif qui a été reçu après émission d'un rayonnement électromagnétique d'activation, et on enregistre, dans une mémoire locale du marqueur RFID actif identifié par l'identifiant (ID_M) émis par les moyens électroniques de localisation, l'identifiant unique (ID_Clᵢ) émis par les moyens électroniques de localisation.
- On fait émettre périodiquement par radiofréquence par chaque marqueur RFID actif (M) au moins son identifiant (ID_M) unique.
- On fait émettre périodiquement par radiofréquence par chaque marqueur RFID actif au moins son identifiant (ID_M) unique, et au moins une autre information, qui peut être l'identifiant unique (ID_Clᵢ) des moyens électroniques de localisation (ICᵢ), ou une information (« LIBRE ») indiquant qu'il n'a pas encore été localisé les moyens électroniques de localisation (ICᵢ).
- Chaque rayonnement électromagnétique d'activation est un rayonnement émis de manière directive et à proximité de l'objet à localiser.
- Chaque rayonnement électromagnétique d'activation est un signal infrarouge.

L'invention concerne également un ensemble d'objets qui sont positionnés de manière amovible dans des emplacements prédéfinis, ledit ensemble étant équipé d'un système de localisation susvisé, de telle sorte que chaque objet est équipé d'un marqueur RFID actif dudit système de localisation, et que chaque position d'émission d'un rayonnement électromagnétique d'activation correspond à un des emplacements prédéfinis.

L'invention concerne également l'utilisation du système de localisation susvisé pour localiser automatiquement et à distance des objets positionnés de manière amovible dans des emplacements prédéfinis, et plus particulièrement pour localiser automatiquement et à distance des équipements informatiques, tels que notamment des serveurs, routeurs, dispositifs de stockage de données, dans au moins une baie informatique.

L'invention concerne enfin un marqueur RFID actif identifié par un identifiant (ID_M), et conçu pour être en permanence alimenté électriquement. Ledit marqueur RFID actif comporte un détecteur de rayonnement électromagnétique, des moyens de d'émission radiofréquence (3), qui sont distincts du détecteur (5) de rayonnement électromagnétique, et est conçu pour émettre par radiofréquence au moins son identifiant (ID_M) lorsqu'il détecte un rayonnement électromagnétique d'activation.

Quelle que soit la variante de réalisation de l'invention, les moyens d'émission radiofréquence de chaque marqueur RFID, et le cas échéant les moyens de réception radiofréquence de chaque marqueur RFID, peuvent avantageusement avoir une portée importante, sans préjudice pour la précision et la fiabilité de localisation des marqueurs, et peuvent notammet avoir une portée supérieure à 1m, et plus préférentiellement encore une portée supérieure à 3m. Il en est de même des moyens de réception radiofréquence des moyens électroniques de localisation, et le cas échéant des moyens d'émission radiofréquence des moyens électroniques de localisation.

### Brève description des figures

D'autre caractéristiques et avantages de l'invention apparaîtront plus clairement à la lecture de la description détaillée ci-après de plusieurs variantes de réalisation de l'invention, lesquelles variantes sont décrites à titre d'exemples non limitatifs et non exhaustifs de l'invention et en référence aux dessins annexés sur lesquels :
- la figure 1 représente un exemple d'architecture d'un système de l'invention appliqué à la localisation d'équipement informatiques, tels que des serveurs informatiques, dans des baies informatiques d'un centre d'hébergement de données ;
- la figure 2 est un schéma d'un exemple d'architecture électronique d'un marqueur RFID actif de l'invention,

- la figure 3 est un schéma d'un exemple d'architecture électronique des moyens de localisation de l'invention (coordinateur d'informations et diodes infrarouge pour l'activation des marqueurs RFID) équipant une baie informatique,
- les figures 4 à 6 sont des organigrammes illustrant le fonctionnement du système de localisation de la figure 1.

### Description détaillée

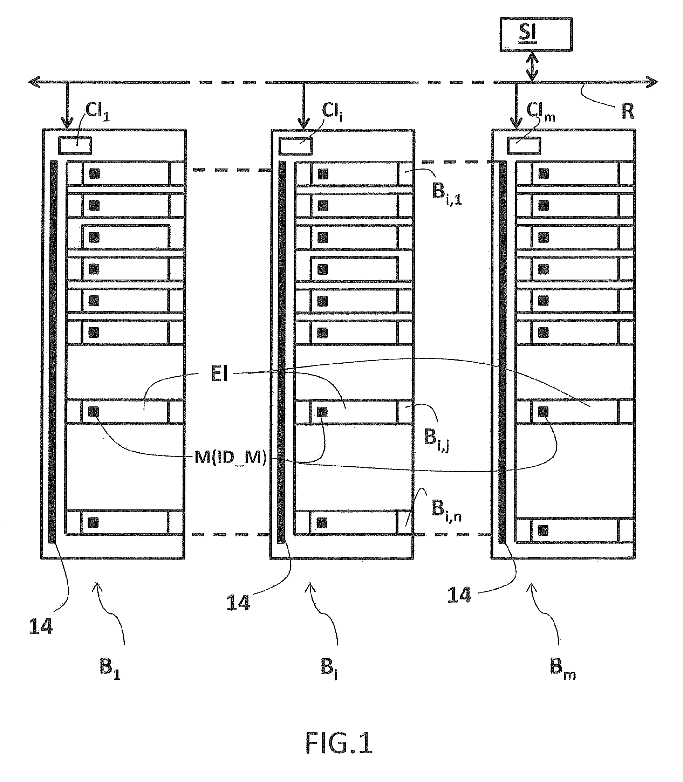

On a représenté de manière schématique sur la figure 1 un centre d'hébergement de données (« Data center ») comportant une pluralité de baies informatiques B₁ à Bₘ. Chaque baie informatique Bᵢ comporte un nombre (n) prédéterminé d'emplacements B_{i,1} à B_{i,n} qui sont communément appelés « slots ». Chaque emplacement est adapté pour recevoir et connecter un équipement informatique El amovible, tel que par exemple un serveur informatique ou un routeur. Dans la suite du présent texte, par soucis de simplification de la description, mais de manière non limitative de l'invention, on considérera que ces équipements informatiques El sont des serveurs informatiques. Le nombre (m) de baies informatiques Bᵢ et le nombre (n) d'emplacements B_{i,j} par baie ne sont pas limitatifs de l'invention. Les baies informatiques Bᵢ ne comportent pas nécessairement le même nombre d'emplacements B_{i,j}.

Chaque serveur El est localisable à distance et de manière automatique au moyen d'un système de localisation, qui est spécifique de l'invention, et dont une variante particulière de réalisation va à présent être détaillée.

Ce système de localisation comporte des marqueurs RFID, référencés M, et désignés également « balises » dans la suite du présent texte et sur les dessins annexés. Chaque balise M est un marqueur RFID actif, qui est en permanence alimenté électriquement, et qui est fixé sur un serveur informatique El, à raison d'une balise M par serveur El.

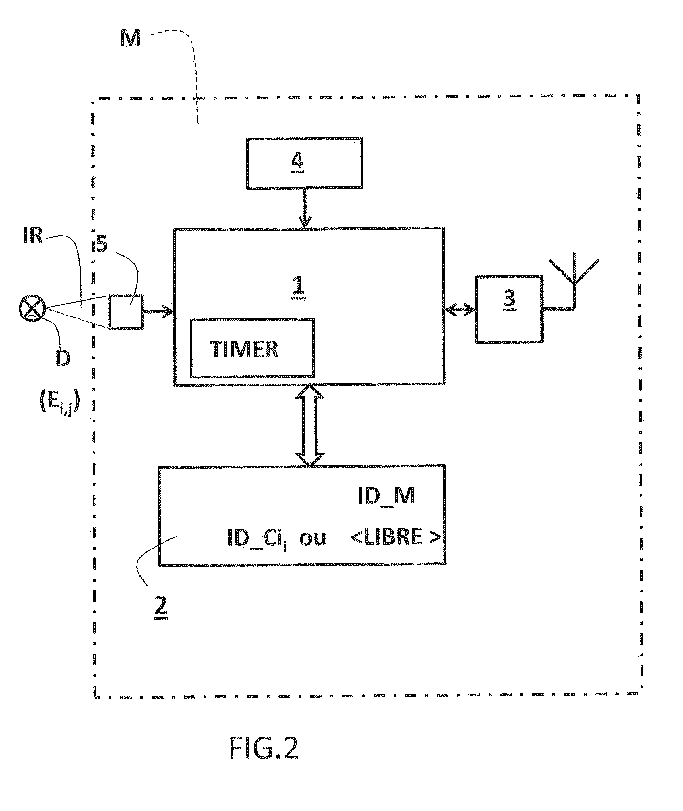

En référence à la figure 2, chaque balise M comporte de manière connue en soi, un microprocesseur 1 pour le traitement de données, une mémoire locale 2, par exemple de type mémoire flash, pour le stockage de données, des moyens d'émission/réception 3 lui permettant d'émettre ou de recevoir des données par radiofréquence, et sa propre source d'alimentation électrique autonome 4.

Dans une variante simplifiée de réalisation l'invention, une balise M peut comporter uniquement des moyens d'émission radiofréquence 3, et ne pas comporter de moyens de réception radiofréquence ; dans ce cas , la balise M est apte uniquement à émettre des données par radiofréquence.

De manière spécifique selon l'invention, chaque balise M comporte également des moyens électroniques de détection 5, qui sont connectés au microprocesseur 1, et qui permettent la détection d'un rayonnement électromagnétique d'activation. De préférence, les moyens électroniques de détection 5 comportent un détecteur infrarouge permettant la détection d'un rayonnement infrarouge IR.

Le système de localisation comporte également à chaque emplacement B_{i,j} de chaque baie informatique Bᵢ, un émetteur E_{i,j} conçu pour émettre sur commande un rayonnement (ou faisceau) électromagnétique directif, qui est désigné par la suite « signal d'activation », et qui est détectable par les moyens de détection 5 d'une balise.

Chaque émetteur E_{i,j} est conçu et positionné au niveau d'un emplacement B_{i,j} d'une baie informatique Bᵢ, de telle sorte qu'une fois un serveur El positionné dans cet emplacement, tout signal d'activation IR émis par l'émetteur E_{i,j}, est détectable uniquement par la balise M qui est fixée sur ce serveur El et n'est pas détectable par les balise M des autres serveurs présents à d'autres emplacements dans la baie informatique Bᵢ ou dans une autre baie informatique.

Plus particulièrement, lorsque les moyens électroniques de détection 5 sont constitués par un détecteur infrarouge, chaque émetteur E_{i,j} est par exemple une diode électroluminescente infrarouge D (figure 2), qui peut émettre un rayonnement infrarouge IR directif, et qui est positionnée au voisinage et au regard du détecteur infrarouge 5 d'une balise M, fixée sur un serveur El positionné dans l'emplacement B_{i,j} de la baie Bi associé à l'émetteur E_{i,j}.

Tous les émetteurs E_{i,j} d'une baie informatique Bᵢ sont connectés à un coordinateur d'informations Clᵢ (figure 1), qui est par exemple fixé sur la baie informatique Bᵢ. En référence à la figure 1, les coordinateurs d'informations Clᵢ de chaque baie informatique Bᵢ sont reliés à un réseau informatique R, qui peut être de type filaire ou sans fil. Sur ce réseau R, est également connecté un système informatique SI, qui peut ainsi communiquer avec l'ensemble des coordinateurs d'informations Clᵢ

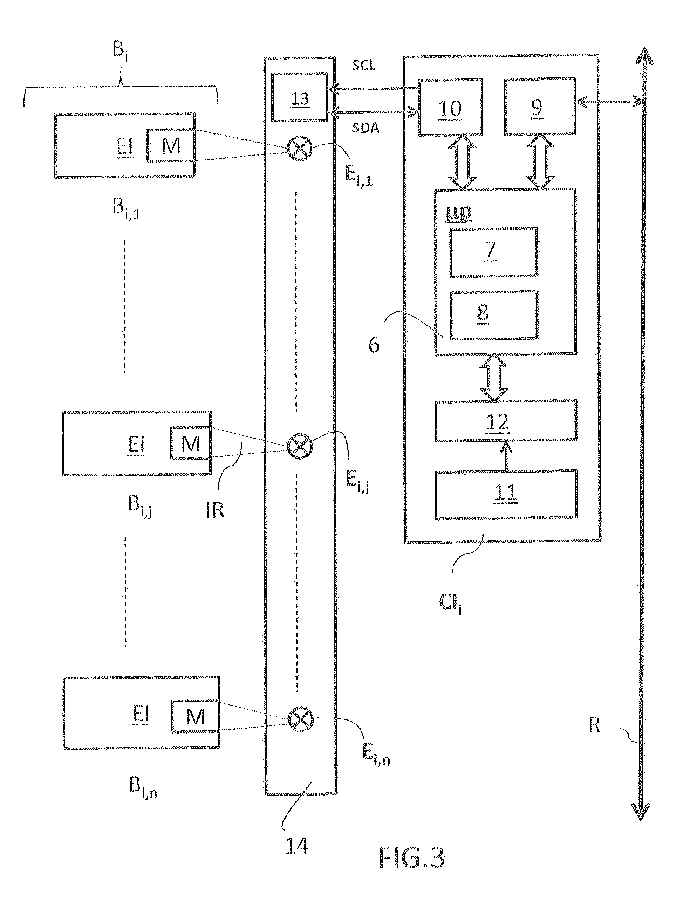

En référence à la figure 3, dans une variante particulière de réalisation, et de manière non limitative de l'invention un coordinateur d'informations Clᵢ peut comporter :
- un microprocesseur ou microcontrôleur 6 associé à de la mémoire 7, 8 pour le stockage de données, type mémoire flash et mémoire vive (RAM)
- un port de communication 9, par exemple de type Ethernet, pour la connexion du coordinateur d'informations Clᵢ à un réseau informatique,
- une interface (I2C) 10 permettant au microprocesseur ou microcontrôleur 6 de commander, au moyen des signaux SCL et SDA, un circuit démultiplexeur 13, qui est connecté aux émetteurs E_{i,j} de la baie Bᵢ au moyen d'un bus d'adressage (non représenté), et qui permet l'adressage individuel de chaque émetteur E_{i,j} de la baie Bi,
- une puce RFID 11 active (en permanence alimentée électriquement) capable de communiquer par radiofréquence avec les balises M de la baie Bᵢ,
- Une interface de communication série 12, par exemple de type RS232, permettant une communication locale entre la puce RFID 11 et le microprocesseur ou microcontrôleur 6.

Dans une variante simplifiée de réalisation l'invention, un coordinateur d'informations Clᵢ eut comporter uniquement des moyens de réception radiofréquence 11, et ne pas comporter de moyens de d'émission radiofréquence ; dans ce cas , ce coordinateur d'informations Clᵢ st apte uniquement à recevoir par radiofréquence des données qui sont émises par les balise M.

Le microprocesseur ou microcontrôleur 6 d'un coordinateur d'informations Clᵢ peut, au moyen des signaux SCL et SDA, commander individuellement chaque émetteur E_{i,j} de la baie Bᵢ, de manière à faire émettre temporairement et individuellement par chaque émetteur E_{i,j} un signal d'activation IR.

En référence à la figure 3, dans une variante particulière de réalisation, pour faciliter la mise en place des émetteurs E_{i,j} dans une baie Bᵢ, on peut avantageusement souder l'ensemble de ces émetteurs E_{i,j} sur un circuit imprimé, constituant un support rigide 14, en forme de réglette, les espacements entre les émetteurs E_{i,j} correspondant aux espacements entre les emplacements B_{i,j} d'un baie Bᵢ.

Dans la variante de la figure 3, le circuit démultiplexeur 13 est également placé sur la réglette 14. Cette réglette 14 peut rapidement être fixée sur une baie Bᵢ, en étant par exemple glissée dans une glissière adaptée de la baie, de telle sorte que chaque émetteur E_{i,j} soit positionné précisément au niveau de l'emplacement auquel il est associé.

Lorsque la baie Bᵢ comporte un nombre important d'émetteurs E_{i,j} il peut également être judicieux de remplacer la réglette unique 14 dₑ grande longueur, par plusieurs réglettes connectables (mécaniquement et électriquement) bout à bout.

Chaque balise M contient en mémoire locale 2 au moins un identifiant ID_M unique, qui lui est spécifique, et qui permet de la différencier des autres balises M.

Egalement, lorsque la balise M a été associée au coordinateur d'informations Clᵢ de sa baie informatique Bᵢ, elle contient en mémoire locale 2 un identifiant ID_Clᵢ qui est spécifique de ce coordinateur d'informations Clᵢ, et qui permet de le différencier des coordinateurs d'informations des autres baies. Lorsque la balise M n'a pas encore été associée au coordinateur d'informations Clᵢ de sa baie informatique Bᵢ, elle contient en mémoire locale 2 un indicateur « LIBRE » signifiant son état non-associé.

Le microprocesseur 1 de chaque balise M gère également un compteur de temps (« TIMER ») de durée programmable, qui est réinitialisable individuellement sur commande du microprocesseur pour chaque balise M, et qui, une fois la durée programmée écoulée, se réinitialise automatiquement pour le décompte d'une nouvelle durée. La durée programmée est par exemple fixée à trente minutes pour chaque balise M.

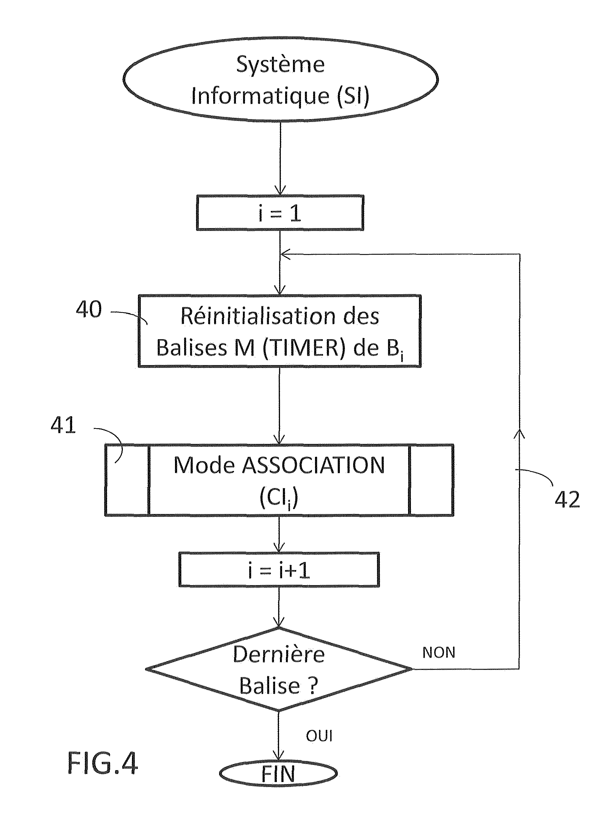

Le fonctionnement du système de localisation va à présent être détaillé en référence aux organigrammes des figures 4 à 6.

### Fonctionnement du système informatique SI - figure 4

Le système informatique SI lance une procédure d'inventaire matérialisée par les étapes de l'organigramme de la figure 4, soit automatiquement (par exemple une fois par jour), soit sur requête d'un utilisateur du système d'informatique SI.

La procédure d'inventaire commence par une étape de réinitialisation des compteurs de temps (« TIMER ») de toutes les balises (figure 4- bloc 40). A cet effet, tous les coordinateurs d'informations Clᵢ commandent séquentiellement dans un laps de temps très court les émetteurs E_{i,i} de leur baie Bᵢ pour qu'ils émettent leur signal d'activation IR (allumage des diodes infrarouge). Chaque balise M détectant un signal d'activation IR réinitialise son compteur de temps (TIMER) et évite ainsi de perturber le mode associatif. Pour cette étape, les Cl ne tiennent pas compte des informations reçues.

Ensuite, le système informatique SI demande séquentiellement (figure 4- boucle itérative 42) à chaque coordinateur d'informations Clᵢ ; d'effectuer l'inventaire de sa baie informatique Bᵢ (figure 4- bloc 41-« Mode ASSOCIATION »)

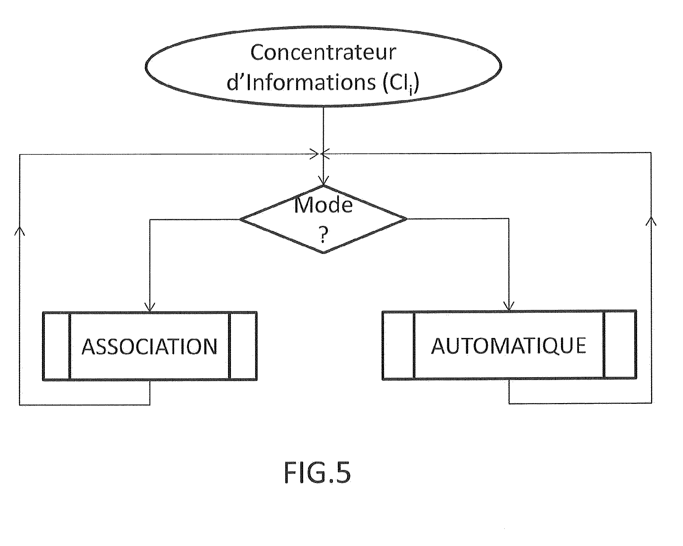

### Fonctionnement des coordinateurs d'informations - figure 5

En référence à la figure 5, chaque coordinateur d'informations Clᵢ possède deux modes de fonctionnement principaux : le mode « ASSOCIATION » précité qui est déclenché par le système d'informatique SI, et un mode dit « AUTOMATIQUE »

En mode « ASSOCIATION », le processeur 6 du coordinateur d'informations Clᵢ exécute automatiquement les opérations suivantes.

Il commande séquentiellement les émetteurs E_{i,j} (diodes infrarouge) de sa baie Bᵢ pour qu'ils émettent chacun à leur tour leur signal d'activation IR, ce qui a pour effet de réveiller les unes après les autres les balises M associées (cf ci-après - Fonctionnement des balises M)

Après émission d'un signal d'activation IR par un émetteur E_{i,j}, plusieurs cas de figure peuvent se présenter :
(1) Un serveur El est positionné à l'emplacement B_{i,j} avec sa balise M correctement positionnée par rapport à l'émetteur Ei,j
   Dans ce cas, le coordinateur d'informations Clᵢ reçoit par radiofréquence l'identifiant unique ID_M de ladite balise M, et mémorise dans une base de données locale (« INVENTAIRE _Clᵢ») cet l'identifiant unique ID_M en association avec la position (connue du coordinateur d'informations Clᵢ) de l'émetteur E_{i,j} dans la baie Bi. Ensuite, le coordinateur d'informations Clᵢ ré-émet par radiofréquence l'identifiant balise ID_M et son identifiant unique ID_Clᵢ, afin que la balise M correspondant à l'identifiant balise ID_M émis s'associe avec le coordinateur Clᵢ en stockant dans sa mémoire locale 2 l'identifiant unique ID_Clᵢ du coordinateur d'informations Clᵢ.
(2) Aucun serveur El n'est positionné à l'emplacement B_{i,j}, ou un serveur El est positionné à l'emplacement B_{i,j} mais sa balise M n'est pas correctement positionnée par rapport à l'émetteur Ei,j et de ce fait ne peut pas être réveillée.
   Dans ce cas, le coordinateur d'informations Clᵢ ne reçoit pas de signal radiofréquence, et après un laps de temps prédéfini, en l'absence de réception d'un signal radiofréquence, le coordinateur d'informations Clᵢ mémorise automatiquement dans la base de données précitée (« INVENTAIRE _Clᵢ») la position (connue du coordinateur d'informations Clᵢ) de l'émetteur E_{i,j} dans la baie Bi en lien avec un indicateur « ABSENCE D'EQUIPEMENT ».

Si une balise n'est pas correctement positionnée, le système informatique SI peut déterminer grâce au mode dit « AUTOMATIQUE » qu'un équipement inventorié ou non se trouve au voisinage d'un Cl.

En mode dit « AUTOMATIQUE », le coordinateur d'informations Clᵢ attend la réception d'un signal radiofréquence.

Lorsqu'il reçoit par radiofréquence son identifiant ID_Clᵢ et l'identifiant ID_M d'une balise M, il vérifie dans sa base de données locale (« INVENTAIRE _Clᵢ») si l'identifiant ID_M est bien enregistré (confirmation de la présence la balise M correspondante dans la baie Bi).

Si le coordinateur d'informations Clᵢ reçoit par radiofréquence l'identifiant ID_M d'une balise M non répertoriée dans sa base de données locale (« INVENTAIRE _Clᵢ») en lien avec une position, cela signifie que la balise M est située dans une autre baie ou n'a pas encore été associée au coordinateur Clᵢ Dans ce cas, il enregistre cet identifiant ID_M sans lien avec une position dans la baie Bᵢ.

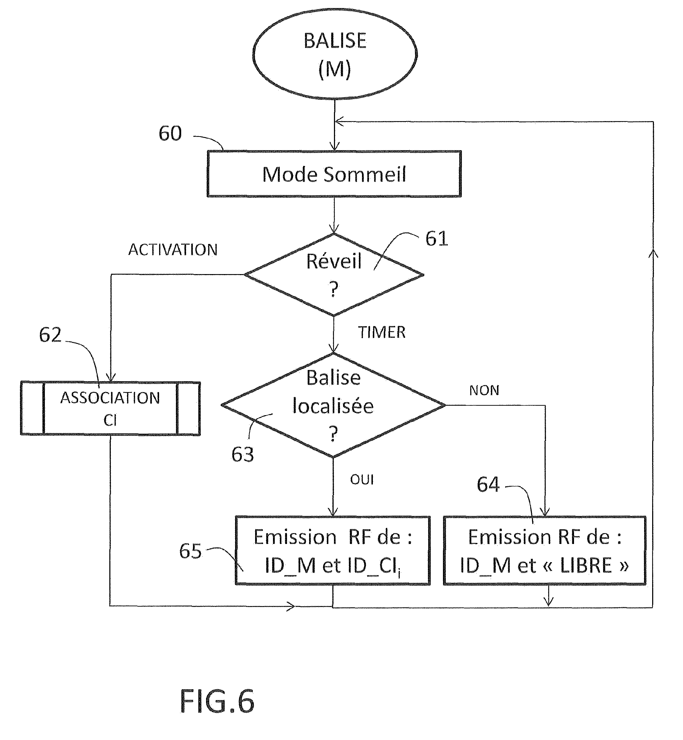

### Fonctionnement des balises M - figure 6

En fonctionnement normal, toutes les balises M de toutes les baies Bᵢ sont en mode sommeil (figure 6 / bloc 60) et n'émettent, ni ne reçoivent, aucune données par radiofréquence. Leur consommation d'énergie en mode sommeil est quasi nulle.

Les balises M peuvent se réveiller temporairement de deux façons (figure 6- test 61) :
- figure 6 - « ACTIVATION » : Par activation de leur détecteur 5 au moyen d'un signal d'activation émis par l'émetteur correspondant E_{i,j}.
- figure 6 - « TIMER » : Après un laps de temps prédéfini (par exemple toutes les trente minutes) contrôlé par le compteur de temps (« TIMER »).

Dans le premier cas (« ACTIVATION »), le microprocesseur 1 de la balise M exécute automatiquement la routine « ASSOCIATION CI » décrite ci-après (figure 6/ bloc 62).

Dans le deuxième cas (« TIMER »), si la balise M n'a pas encore été associée à un coordinateur d'informations Clᵢ (figure 6 - test 63), elle émet par radiofréquence (figure 6 - bloc 64) son identifiant unique ID_M, ainsi que son état « LIBRE ». Si la balise est associée à un coordinateur d'informations Clᵢ (figure 6 - test 63), elle émet par radiofréquence (figure 6 - bloc 65) son identifiant unique ID_M, ainsi que l'identifiant ID_Clᵢ du coordinateur d'informations Clᵢ auquel elle est associée.

Une fois ces opérations terminées, la balise M se remet automatiquement en mode veille (figure 6 - bloc 60).

### routine « ASSOCIATION CI »

Lorsque cette routine (figure 6 - bloc 62) est exécutée, les opérations successives suivantes sont déclenchées.

Le microprocesseur 1 de la balise M réinitialise le compteur de temps « TIMER » de la balise M et la balise M émet par radiofréquence son identifiant unique ID_M.

Cet identifiant unique ID_M est reçu par le coordinateur Clᵢ de la baie informatique Bᵢ dans laquelle est positionné le serveur El associé à la balise M qui a émis son identifiant ID_M, ce qui déclenche l'émission radiofréquence par le coordinateur d'informations Clᵢ de son identifiant unique ID_Clᵢ et de l'identifiant balise ID_M (cf mode « ASSOCATION » précédemment décrit). Ensuite, la balise M correspondant à l'identifiant balise ID_M émis s'associe avec le coordinateur Clᵢ en stockant dans sa mémoire locale 2 l'identifiant unique ID_Clᵢ du coordinateur d'informations Clᵢ.

Le système informatique SI peut accéder aux informations qui sont stockées au niveau de chaque coordinateur d'informations Clᵢ dans chaque base de données locale (« INVENTAIRE _Clᵢ»), afin par exemple de localiser un serveur El dans une baie Bi ou de suivre automatiquement dans le temps les opérations d'extraction ou d'insertion d'un serveur El dan une baie informatique Bi. Pour localiser un serveur El, il suffit au système informatique SI d'interroger les bases de données locales (« INVENTAIRE _Clᵢ») avec comme clef d'entrée l'identifiant balise ID_M du serveur El à localiser.

L'invention n'est pas limitée à la mise en oeuvre d'une pluralité d'émetteurs Ei,j ayant des positions fixes. Dans une autre variante de réalisation, on peut remplacer les d'émetteurs fixes E_{i,j} d'une baie Bᵢ, par un émetteur de rayonnement électromagnétique d'activation, qui est mobile de manière à pouvoir être positionné automatiquement par le coordinateur d'information Clᵢ de la baie dans des positions différentes correspondant respectivement aux emplacements prédéfinis B_{i,j} e la baie Bᵢ.

Plus particulièrement, cet l'émetteur mobile peut être une source laser mobile, par exemple montée sur une tourelle, de manière à pouvoir balayer tous les emplacement B_{i,j} de la baie.

L'invention n'est pas limitée à la mise en oeuvre de rayonnements d'activation dans la gamme de longueur d'ondes de l'infrarouge, mais peut être mise en oeuvre avec des rayonnements d'activation dans des gammes de longueur d'ondes différentes en dehors du domaine infrarouge.

L'invention n'est pas limitée à la localisation automatique d'équipements informatiques El dans des baies informatiques Bᵢ, mais peut plus généralement être utilisée pour localiser automatiquement tout type d'objets destinés à être positionnés de manière amovible dans des emplacements prédéfinis.

## Revendications

1. Système pour la localisation d'objets (El) destinés à être positionnés de manière amovible dans des emplacements prédéfinis (B_{i,j}), ledit système comportant des marqueurs RFID (M), qui sont chacun identifiés par un identifiant unique (ID_M), chaque marqueur RFID étant destiné à être fixé sur un objet à localiser, les marqueurs RFID (M) sont des marqueurs actifs en permanence alimentés électriquement, chaque marqueur RFID actif (M) comporte des moyens électroniques de détection (5) d'un rayonnement électromagnétique d'activation de manière à pouvoir être réveillé individuellement par un rayonnement électromagnétique d'activation, et des moyens d'émission radiofréquence (3) qui sont distincts des moyens électroniques de détection (5), chaque marqueur RFID (M) étant conçu pour émettre automatiquement par radiofréquence au moins son identifiant (ID_M) unique chaque fois qu'il est réveillé par un rayonnement électromagnétique d'activation, ledit système comporte en outre des moyens électroniques de localisation (Clᵢ) qui sont aptes à recevoir les identifiants (ID_M) émis par radiofréquence par les marqueurs RFID actifs, et qui sont conçus pour, après chaque émission d'un rayonnement électromagnétique d'activation, localiser automatiquement un marqueur RFID actif (M) qui a été réveillé, en utilisant la position d'émission connue du rayonnement électromagnétique d'activation dernièrement émis et l'identifiant (ID_M) qui a été reçu après émission dudit rayonnement électromagnétique d'activation.

2. Système selon la revendication 1, dans lequel chaque marqueur RFID comporte des moyens de réception radiofréquence (3), dans lequel les moyens électroniques de localisation (Clᵢ) sont identifiés par un identifiant unique (ID_Clᵢ), et sont conçus pour, après chaque émission d'un rayonnement électromagnétique d'activation et en cas de réception d'un identifiant (ID_M) d'un marqueur (M), émettre, par radiofréquence, leur identifiant unique (ID_Clᵢ), et l'identifiant (ID_M) du marqueur RFID actif (M) qui a été reçu après émission dudit rayonnement électromagnétique d'activation, et dans lequel le marqueur RFID actif (M) identifié par l'identifiant (ID_M) émis par les moyens électroniques de localisation (Clᵢ) est conçu pour enregistrer dans une mémoire locale (2) du marqueur (M) l'identifiant unique (ID_Clᵢ) émis par les moyens électroniques de localisation (Clᵢ).

3. Système selon l'une quelconque des revendications 1 à 2, dans lequel chaque marqueur RFID actif (M) est conçu pour automatiquement émettre périodiquement par radiofréquence au moins son identifiant (ID_M).

4. Système selon la revendication 3, dans lequel chaque marqueur RFID actif (M) est conçu pour automatiquement émettre périodiquement par radiofréquence au moins son identifiant (ID_M) et au moins une autre information, qui peut être l'identifiant (ID_Clᵢ) des moyens électroniques de localisation (Clᵢ), ou une information (« LIBRE ») indiquant qu'il n'a pas encore été localisé par les moyens électroniques de localisation (Clᵢ).

5. Système selon l'une quelconque des revendications 1 à 4, dans lequel les moyens électroniques de localisation comportent des moyens d'émission qui sont aptes à émettre un rayonnement électromagnétique d'activation séquentiellement depuis plusieurs positions d'émission prédéfinies et différentes correspondant respectivement aux emplacements prédéfinis (B_{i,j}).

6. Système selon la revendication 5, dans lequel les moyens d'émission d'un rayonnement électromagnétique comportent plusieurs émetteurs distincts (E_{i,j}) aptes chacun à émettre un rayonnement électromagnétique d'activation, chaque émetteur (E_{i,j}) ayant une position fixe correspondant à un emplacement (B_{i,j}), à raison d'un émetteur (E_{i,j}) par emplacement (B_{i,j}).

7. Système selon la revendication 6, dans lequel les moyens électroniques de localisation sont conçus pour commander séquentiellement les émetteurs distincts (E_{i,j}) afin qu'ils génèrent chacun à leur tour un signal électromagnétique d'activation.

8. Système selon l'une quelconque des revendications 6 ou 7, dans lequel les émetteurs (E_{i,j}) sont des diodes électroluminescentes.

9. Système selon l'une quelconque des revendications 6 à 8, dans lequel les émetteurs (E_{i,j}) sont fixés sur un support rigide (14) avec un espacement entre les émetteurs (E_{i,j}) correspondant à l'espacement entre les emplacements (B_{i,j}).

10. Système selon la revendication 5, dans lequel les moyens d'émission d'un rayonnement électromagnétique comportent un émetteur de rayonnement électromagnétique d'activation, qui est mobile de manière à pouvoir être positionné dans des positions différentes correspondant respectivement aux emplacements prédéfinis (B_{i,j}).

11. Système selon la revendication 10, dans lequel l'émetteur de rayonnement électromagnétique d'activation est une source laser mobile.

12. Système selon l'une quelconque des revendications 1 à 11, dans lequel les moyens électroniques de localisation comportant au moins des moyens de réception radiofréquence (11), et de préférence également des moyens d'émission radiofréquence, qui permettent aux moyens électroniques de localisation de communiquer à distance par radiofréquence avec les marqueurs RFID (M), lesdits moyens de réception radiofréquence (11), et le cas échéant lesdits moyens d'émission radiofréquence, sont distincts des moyens d'émission du rayonnement électromagnétique d'activation.

13. Système selon l'une quelconque des revendications 1 à 12, dans lequel chaque rayonnement électromagnétique d'activation est un rayonnement directif.

14. Système selon l'une quelconque des revendications 1 à 13, dans lequel chaque rayonnement électromagnétique d'activation est un signal infrarouge (IR).

15. Système selon l'une quelconque des revendications 1 à 14, dans lequel chaque marqueur RFID actif (M) comporte sa propre source d'alimentation électrique autonome (4).

16. Procédé de localisation d'objets (El) positionnés de manière amovible dans des emplacements prédéfinis (B_{i,j}), dans lequel on fixe à chaque objet un marqueur RFID (M), qui est identifié par un identifiant unique (ID_M), dans lequel les marqueurs RFID (M) sont des marqueurs actifs en permanence alimentés électriquement, dans lequel chaque marqueur RFID actif (M) comporte des moyens électroniques de détection (5) d'un rayonnement électromagnétique d'activation de manière à pouvoir être réveillé par un rayonnement électromagnétique d'activation, comporte des moyens d'émission radiofréquence (3), qui sont distincts des moyens électroniques de détection (5), et émet automatiquement par radiofréquence au moins son identifiant (ID_M) unique chaque fois qu'il est réveillé par un rayonnement électromagnétique d'activation, dans lequel on met en oeuvre des moyens électroniques de localisation comportant des moyens d'émission d'un rayonnement électromagnétique d'activation, et au moins des moyens de réception radiofréquence (11), et de préférence également des moyens d'émission radiofréquence, qui sont distincts des moyens d'émission du rayonnement électromagnétique d'activation, et qui permettent aux moyens électroniques de localisation de communiquer à distance par radiofréquence avec les marqueurs RFID (M), et dans lequel on met en oeuvre la succession d'étapes suivantes :
(a) les moyens électroniques de localisation émettent à l'un des emplacements prédéfinis (B_{i,j}) un rayonnement électromagnétique d'activation,
(b) les moyens électroniques de localisation détectent la présence ou non d'un objet (El) positionné audit emplacement (B_{i,j}) à partir de la réception ou non par radiofréquence d'un identifiant (ID_M), et
(c) en cas de réception par radiofréquence d'un identifiant (ID_M), les moyens électroniques de localisation identifient automatiquement ledit objet (El) au moyen de l'identifiant (ID_M) reçu, et localisent automatiquement ledit objet (El) en utilisant la position connue d'émission du rayonnement électromagnétique d'activation dernièrement émis.

17. Ensemble d'objets (El), et notamment équipements informatiques (El), serveurs, routeurs, dispositifs de stockage de données, qui sont positionnés de manière amovible dans des emplacements prédéfinis (B_{i,j}), ledit ensemble étant équipé d'un système de localisation visé à l'une quelconque des revendications des revendications 1 à 15, de telle sorte que chaque objet (El) est équipé d'un marqueur RFID actif (M) dudit système de localisation, et que chaque position d'émission d'un rayonnement électromagnétique d'activation correspond à un des emplacements prédéfinis (B_{i,j}).

18. Marqueur RFID actif (M) identifié par un identifiant (ID_M), et conçu pour être en permanence alimenté électriquement, **caractérisé en ce qu'il** comporte un détecteur (5) de rayonnement électromagnétique, et des moyens de d'émission radiofréquence (3), qui sont distincts du détecteur (5) de rayonnement électromagnétique, et **en ce qu'**il est conçu pour émettre par radiofréquence au moins son identifiant (ID_M) lorsqu'il détecte un rayonnement électromagnétique d'activation.
